# EUROPÄISCHE PATENTSCHRIFT

(11) **EP 0 703 618 B1**
(45) Veröffentlichungstag und Bekanntmachung des Hinweises auf die Patenterteilung: **06.06.2001**
(21) Anmeldenummer: 95113423.8
(22) Anmeldetag: 26.08.1995
(51) Int. Cl.: H01L 25/065, H01L 21/98

(54) **Verfahren zur Herstellung einer dreidimensionalen integrierten Schaltung**
Method for fabricating a three dimensional integrated circuit
Procédé pour fabriquer un circuit intégré tridimensionnel

(30) Priorität: 22.09.1994 DE 4433845
(43) Veröffentlichungstag der Anmeldung: 27.03.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: Ramm, Peter, Dr., D-85276 Pfaffenhofen (DE); Buchner, Reinhold, Dipl.-Phys., D-85774 Unterföhring (DE)

(56) Entgegenhaltungen:
- EP-A- 0 531 723
- DE-C- 4 314 913
- INTERN. ELECTRON DEVICES MEETING, 8. Dezember 1991, WASHINGTON Seiten 25.6.1 - 25.6.4 Y. HAYASHI ET AL. 'a new three dimensional ic fabrication technology, stacking thin film dual-cmos layers'
- MICROELECTRONIC ENGINEERING, Bd.15, Nr.1/4, Oktober 1991, AMSTERDAM Seiten 167 - 174 T. MORIYA ET AL. 'results of the three-dimensional integrated circuits project in japan'

## Beschreibung

Die Erfindung betrifft ein Verfahren zur Herstellung einer dreidimensionalen integrierten Schaltung. Unter dreidimensionaler Integration versteht man die vertikale Verbindung von Bauelementen, die mittels Planartechnik hergestellt wurden. Die Vorteile eines dreidimensional integrierten mikroelektronischen Systems sind u.a. die bei gleichen Designregeln erreichbaren höheren Packungsdichten und Schaltgeschwindigkeiten gegenüber zweidimensionalen Systemen. Letzteres ist zum einen bedingt durch kürzere Leitungswege zwischen den einzelnen Bauelementen oder Schaltungen, zum anderen durch die Möglichkeit der parallelen Informationsverarbeitung. Die Steigerung der Leistungsfähigkeit des Systems ist bei Realisierung einer Verbindungstechnik mit örtlich frei wählbaren höchstintegrierbaren vertikalen Kontakten optimal.

Zur Herstellung dreidimensionaler Schaltungsanordnungen mit frei wählbaren vertikalen Kontakten sind folgende Verfahren bekannt:

Y. Akasaka, Proc. IEEE 74 (1986) 1703, schlägt vor, auf eine fertig prozessierte Bauelementeschicht polykristallines Silizium abzuscheiden und zu rekristallisieren, so daß in der rekristallisierten Schicht weitere Bauelemente gefertigt werden können. Nachteile dieser Methode sind die ausbeutereduzierende Degradation der Bauelemente in der unteren Ebene durch die hohe thermische Belastung beim Rekristallisierungsprozeß, sowie die notwendigerweise serielle Prozessierung des Gesamtsystems. Letzteres bedingt zum einen entsprechend lange Durchlaufzeiten bei der Fertigung und hat zum anderen eine Ausbeuteminderung durch Aufsummierung der prozeßbedingten Ausfälle zur Folge. Beides erhöht die Fertigungskosten beträchtlich gegenüber einer Prozessierung der einzelnen Ebenen getrennt voneinander in verschiedenen Substraten.

Aus Y. Hayashi et al., Proc. 8th Int. Workshop on Future Electron Devices, 1990, p. 85, ist es bekannt, zunächst die einzelnen Bauelementeebenen getrennt voneinander in verschiedenen Substraten herzustellen. Anschließend werden die Substrate auf wenige Mikrometer gedünnt, mit Vorder- und Rückseitenkontakten versehen und mittels eines Bondverfahrens vertikal verbunden. Für die Bereitstellung der Vorder- und Rückseitenkontakte sind jedoch Sonderprozesse notwendig sind, die in der Standard - Halbleiterfertigung (CMOS) nicht vorgesehen sind, nämlich MOS - inkompatible Materialien (z.B. Gold) und Rückseitenstrukturierung des Substrates.

Die US 4,939,568 beschreibt ein Verfahren zur Herstellung einer dreidimensionalen integrierten Schaltungsstruktur durch Stapelung einzelner ICs zu einem Einzelchipstapel auf einem Trägersubstrat. Hierzu wird zunächst ein Substrat mit fertigprozessierten ICs in einzelne Chips unterteilt, womit die Prozessierung auf Waferebene beendet ist. Die Chips werden getestet, und ein erster einzelner Chip wird mittels Thermokompression auf ein Trägersubstrat aufgebracht. Nach diesem Schritt wird ein weiterer Chip in der gleichen Weise auf den ersten Chip aufgebracht. Es wird somit zunächst ein erster Chipstapel fertiggestellt, bevor mit der Herstellung eines weiteren Chipstapels auf einem anderen Trägersubstrat begonnen wird. Eine Weiterprozessierung der Chipstapel auf Waferebene ist mit diesem Verfahren daher nicht möglich.

Aus der EP-A-0531723 ist ein Verfahren zur Herstellung dreidimensionaler Multichip-Stapel bekannt. Dabei werden vereinzelte Chips dergestalt mit einem geeigneten Träger verbunden, daß die Schutzoberfläche des Chips angrenzend an die obere Oberfläche des Trägers angeordnet ist. In einem folgenden Schritt wird die freiliegende zweite Oberfläche des Chips in einer geeigneten Ätzlösung geätzt. Anschließend werden weitere Schichten aufgebracht, und der Stapelprozeß wird dann wiederholt, indem Chips jeweils aufeinander hinzugefügt werden, wobei jeder seine aktive Schicht angrenzend an die zuletzt gedünnte freiliegende Oberfläche des Stapels positioniert hat. Dabei werden bei einer Vereinzelung der Chips jeweils nur die funktionsfähigen Chips ausgewählt. Alternativ kann auch eine wafermäßige Bearbeitung der Chips stattfinden, dabei findet jedoch keine Auswahl der funktionsfähigen Chips statt.

Darüber hinaus wird in International Electron Devices Meeting, 8. Dezember 1991, Seiten 25.6.1. bis 25.6.4.,Y. Hayashi et al. "A New Three-Dimensional IC Fabrication Technology, Stacking Thin Film Dual-CMOS Layers" eine neuartige dreidimensionale integrierte Schaltung beschrieben, bei dem Blöcke aus sogenanntem Dünnfilm DUAL-CMOS ICs miteinander verbunden werden. In diesen DUAL-CMOS ICs werden p-MOSFETs auf n-MOSFETs gestapelt, indem eine Laserstrahl-Tempertechnik verwendet wird. Durch mechanisch-chemisches Polieren werden die Substrate der integrierten Schaltungen gedünnt und dann miteinander verbunden. Darüber hinaus ist aus der deutschen Patentschrift Nr. 43 14 913 ein Verfahren zur Herstellung eines Bauelements mit einer Kontaktstrukturierung für vertikale Kontaktierung mit weiteren Halbleiterbauelementen bekannt. Das Halbleiterbauelement mit einer Kontaktstrukturierung für vertikale Kontaktierung mit weiteren Bauelementen weist ein Substrat auf, das auf einer Oberseite eine Schichtstruktur mit zu kontaktierenden Bereichen aufweist, bei dem mindestens ein Metallstift vorhanden ist, der dieses Substrat senkrecht zu der Schichtstruktur durchbohrt, bei dem das Substrat soweit gedünnt ist, daß der Metallstift die Unterseite des Substrats überragt und bei der gegebenenfalls auf der Oberseite Metallkontakte aus niedrigschmelzendem Metall vorhanden sind.

Ein wesentlicher Nachteil der bisher genannten Verfahren ist dadurch bedingt, daß die in der Siliziumtechnologie zur Verfügung stehenden Geräte nur eine Bearbeitung (Prozessierung) von scheibenförmigen Substraten, den sog. Wafern, zulassen. Eine Prozessierung davon verschiedener Substrate, insbesondere von einzelnen Chips, ist nur in experimentellen Versuchsanlagen möglich, jedoch nicht im Rahmen einer industriellen Fertigung mit den geforderten hohen Ausbeuten.

Die US 4,954,875 beschreibt ein Verfahren zur dreidimensionalen Integration durch Stapelung einzelner Wafer, bei dem die Verbindung der einzelnen Bauelementeebenen über besonders geformte Vias hergestellt wird.
Beim Zusammenfügen von Substraten, die eine Vielzahl von identischen Bausteinen, den sog. Chips, enthalten, ergibt sich die resultierende Ausbeute eines mehrlagigen Systems aus dem Produkt der Einzelausbeuten. Dies führt dazu, daß die Ausbeute eines mehrere Bauelementeebenen umfassenden Systems, wie das der US 4,954,875 nach den bekannten Verfahren drastisch abnimmt. So erhält man bei einer Ausbeute einer Einzelebene von 80 % bei einem Gesamtsystem aus 10 Ebenen nur mehr eine resultierende Gesamtausbeute von etwa 10 %, womit ein derartiges System unwirtschaftlich wird und der Einsatz dieser Technik auf wenige spezielle Einsatzfelder beschränkt wird. Die Ausbeute eines Bauelementesubstrates hängt dabei auch von der Art der Schaltungen und des verwendeten Herstellungsprozesses ab. So erzielt man z.B. in der Fertigung von Speicherbausteinen sehr hohe Ausbeuten, während bei Logikbausteinen, wie Mikroprozessoren, eine deutlich geringere Ausbeute erreicht wird. Insbesondere wenn mehrere Arten solcher Schaltungen übereinandergestapelt werden, wird damit die Gesamtausbeute überproportional durch die Schaltungsart mit der geringsten Ausbeute bestimmt.

Der Erfindung liegt die Aufgabe zugrunde, ein Verfahren zur Herstellung einer dreidimensionalen integrierten Schaltung anzugeben, mit dem unter Verwendung der üblichen industriellen Standardausrüstung auf Waferebene eine deutliche Ausbeutesteigerung gegenüber bisher bekannten Verfahren erzielt wird.

Diese Aufgabe wird erfindungsgemäß mit dem Verfahren nach Anspruch 1 gelöst. Besondere Ausgestaltungen des Verfahrens sind Gegenstand der Unteransprüche.

In dem erfindungsgemäßen Verfahren werden zwei fertig prozessierte Substrate (Wafer), die jeweils Schaltungsstrukturen und Metallisierungsebenen enthalten, beispielsweise über eine Haftschicht miteinander verbunden. Die Haftschicht kann hierbei zusätzlich eine passivierende Funktion ausüben (Anspruch 7) und/oder eine Planarisierung der Oberfläche bewirken (Anspruch 8). Dabei wird das obere Substrat (zweites Substrat) vorher einem Funktionstest unterzogen, mit dem die intakten Chips des Substrates selektiert werden. Anschließend wird dieses Substrat von der Rückseite her gedünnt und in einzelne Chips zerlegt. Danach werden nur selektierte, intakte Chips auf das, mit einer Haftschicht versehene, untere Substrat (erstes Substrat) nebeneinander justiert aufgebracht und damit zu einer neuen Chipebene zusammengesetzt. Auf diese Weise wird ein Wafer bereitgestellt, der in der neu aufgebrachten Chipebene nur intakte Chips enthält.
Das untere Substrat kann hierbei auch bereits mehrere Bauelementelagen in Form von Bauelementestapeln enthalten. Die Chips des oberen Substrates werden entweder im Rahmen des Verfahrens dem Funktionstest unterzogen (Anspruch 2) oder es wird ein bereits geprüftes Substrat mit getesteten und z.B. markierten defekten Chips bereitgestellt und eingesetzt. Auf das obere Substrat wird schließlich vor dem Dünnen und Zerteilen ein Hilfssubstrat aufgebracht. Statt des Dünnens des oberen Substrates bis nahe an die Bauelementelagen heran kann auch im Falle eines SOI-Substrates der Substratbereich unterhalb der Oxidschicht entfernt werden.

Da auf dem unteren Substrat nun einzelne Chips aufgebracht worden sind, ist keine zusammenhängende Oberfläche mehr vorhanden (Gräben zwischen den Chips), so daß bestimmte Prozeßschritte, insbesondere Photolithographiemodule, nicht mehr mit hoher Ausbeute durchgeführt werden können. Deshalb wird nun vorzugsweise ein Planarisierungsschritt eingefügt (Anspruch 9).
Die Planarisierung kann mit verschiedenen Verfahren durchgeführt werden. Dabei wird zuerst eine Isolationsschicht, wie z.B. Spin-on-Glas oder ein CVD - Oxid, aufgebracht, um die Gräben aufzufüllen. Anschließend wird die Oberfläche eingeebnet, was durch Rückätzen, mechanisches oder chemomechanisches Schleifen erfolgt.
Weitere Prozesse, die nicht auf Chipebene realisierbar sind, können nach dem Planarisierungsschritt problemlos an dem Substrat mit vorselektierten Chips durchgeführt werden.

Anschließend wird z.B. über Vialöcher (Anspruch 10), die bereits bei der Prozessierung der Einzelsubstrate in die Chips eingebracht wurden und nun bis zu einer Metallisierungsebene des unteren Substrates durchgeätzt werden, die elektrische Verbindung zwischen je einer Metallisierungsebene der oberen und der unteren Schaltungsebene hergestellt. Dabei wird die Photomaske zur Strukturierung auf jeden einzelnen Chip über Justierstrukturen separat justiert, um etwaige Maßabweichungen durch das Aufbringen der einzelnen Chips auszugleichen und eine hohe Justiergenauigkeit zu erreichen.

Danach kann das Substrat, das in der Bauelementeebene nur noch getestete und funktionsfähige Chips enthält, in gängigen Fertigungsanlagen weiter verarbeitet werden.

In gleicher Weise kann nun auch eine weitere Bauelementeebene chipweise aufgebracht werden (Anspruch 3). Hierbei dient der bisher hergestellte Bauelementestapel mit zugehörigem Substrat als neues unteres Substrat. Dabei ist bei diesem Verfahren die Anzahl der Ebenen nicht beschränkt. Außerdem kann nicht nur eine Einzelebene, sondern auch ein bereits aus mehreren Ebenen bestehender Teilstapel chipweise aufgebracht werden.

Als Substrate sind monokristalline Siliziumsubstrate, SOI - Substrate oder Substrate verschiedener Technologiefamilien, wie z.B. III - V - Halbleiter geeignet.

Insgesamt werden bei diesem Verfahren nur bekannte und eingeführte Verfahrensschritte verwendet, so daß keine neuen Prozesse entwickelt werden müssen.
Mit dem erfindungsgemäßen Verfahren werden nur intakte Chips jeweils auf die darunterliegenden Bauelementelagen aufgebracht. Damit wird in vorteilhafter Weise die Abhängigkeit der Ausbeute des Gesamtsystems von der Ausbeute der einzelnen prozessierten Substrate stark verringert. Es können jeweils nur einzelne defekte Chips einer Bauelementelage ausgesondert werden, so daß nicht mehr ganze Bauelementestapel aufgrund einer einzigen defekten Lage unbrauchbar werden. Durch das erfindungsgemäße Verfahren werden somit die Ausbeute bei der Herstellung dreidimensionaler integrierter Schaltungen deutlich gesteigert und die Herstellungskosten gesenkt.

Im folgenden wird die Erfindung anhand der Zeichnungen und eines Ausführungsbeispiels näher erläutert.

Dabei zeigen:
- Fig. 1: ein erstes Bauelementesubstrat mit Schaltungsstrukturen und Metallisierungsebenen (unteres Substrat),
- Fig. 2: ein zweites Bauelementesubstrat mit Schaltungsstrukturen, Metallisierungsebenen und Vialöchern (oberes Substrat),
- Fig. 3: das zweite Bauelementesubstrat mit Haftschicht und Hilfssubstrat,
- Fig. 4: das erste Bauelementesubstrat mit einer chipweise aufgebrachten zweiten Bauelementeebene nach Planarisierung der Oberfläche, und
- Fig. 5: zwei vertikal verbundene Bauelementeebenen.

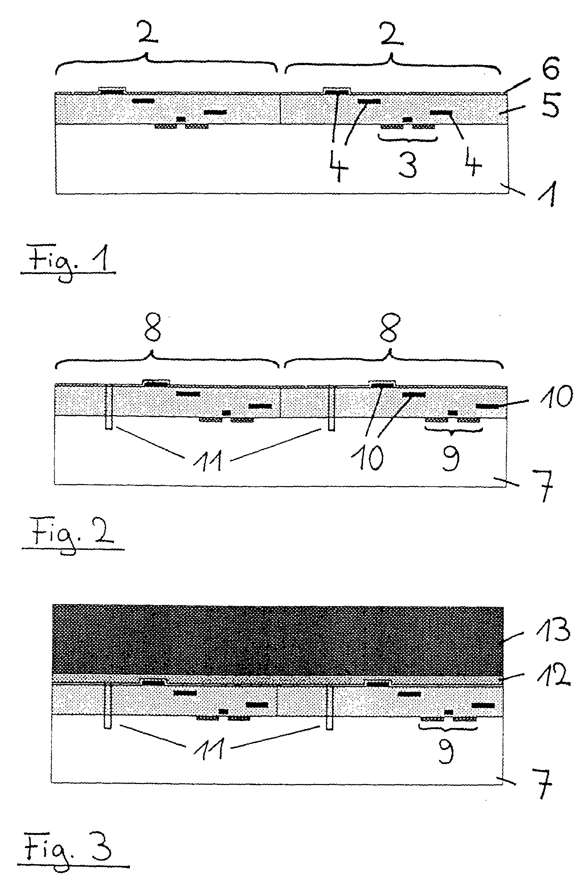

Ein erstes Bauelementesubstrat 1 aus z.B. monokristallinem Silizium umfaßt mehrere, nach einem definierten Schema angeordnete, üblicherweise identische Chips 2, die Schaltungsstrukturen 3, wie beispielsweise einen MOS - Transistor, und eine oder mehrere Metallisierungsebenen 4 enthalten, die typischerweise aus Aluminum, einer Aluminiumlegierung oder anderen Materalien, wie Kupfer oder Wolfram, bestehen und zur elektrischen Isolation von einer Oxidschicht 5, die zu Planarisierungszwecken auch mit Bor und / oder Phosphor dotiert sein kann, umgeben sind. Die oberste Metallisierungsebene 4 kann dabei auch von einer Passivierungsschicht 6 aus beispielsweise Siliziumoxid und Siliziumnitrid bedeckt sein. Weiterhin sind Justagestrukturen zum genauen Zusammenfügen mehrerer Ebenen implementiert (in Fig. 1 nicht gezeigt). Unterhalb der Schaltungsstrukturen 3 weist das Substrat eine Dicke von z.B. 625 µm auf. Dieses Bauelementesubstrat stellt das untere Substrat des mehrlagigen Systems dar (Fig. 1).

Ein zweites Bauelementesubstrat 7 umfaßt ebenfalls mehrere, nach einem definierten Schema angeordnete, üblicherweise identische Chips 8, die Schaltungsstrukturen 9, wie beispielsweise einen MOS - Transistor, und eine oder mehrere Metallisierungsebenen 10 enthalten. Dieses Substrat 7 ist im wesentlichen ähnlich aufgebaut wie das erste Bauelementesubstrat 1, die Schaltungsstrukturen 9 sind aber in der Regel von ihrer Funktion her unterschiedlich. Desweiteren weist das zweite Bauelementesubstrat Vialöcher 11 an den Stellen auf, an denen später die elektrische Kontaktierung zu darunterliegenden Schaltungsstrukturen des ersten Substrates erfolgen soll. Die Vialöcher 11 sind so tief, daß sie bis unterhalb der Schicht mit Schaltungsstrukturen 9 reichen (Fig. 2).
Nach Fertigstellung des Bauelementesubstrates 7 wird die Passivierung auf der obersten Metallisierungsebene an bestimmten Meßstellen geöffnet. Danach werden die einzelnen Chips des Substrates einem Funktionstest unterzogen und die defekten Chips gekennzeichnet (z.B. mit einem Tintenstrahl). Anschließend wird erneut eine Passivierungsschicht aufgebracht, um die offenliegenden Meßstellen wieder zu schützen.

Auf die Oberfläche des zweiten Substrates 7 wird ganzflächig eine Haftschicht 12 aus einem organischen Material, wie Polyimid oder Photolack, aufgebracht. Diese Haftschicht 12 mit einer Dicke von typischerweise 1 - 2 µm kann außerdem eine Planarisierung der Oberfläche bewirken. Auf die Haftschicht 12 wird schließlich ein Hilfssubstrat 13, wie beispielsweise ein Silizium- oder Quarzwafer, geklebt. Das Hilfssubstrat 13 wird als Handlingsubstrat für die weiteren Prozeßschritte verwendet und schützt die Oberfläche des Bauelementesubstrates 7 bei der weiteren Bearbeitung. (Fig. 3).

Danach wird das zweite Bauelementesubstrat 7 durch Ätzen und/oder Schleifen von der Rückseite her bis an die Vialöcher 11 heran gedünnt, so daß die Dicke des Substrates 7 unterhalb der Schaltungsstrukturen 9 nur noch wenige Mikrometer, typischerweise 1 - 5 µm, beträgt. Dabei hängt die gewählte Restdicke auch von der Art der enthaltenen Schaltungen ab.

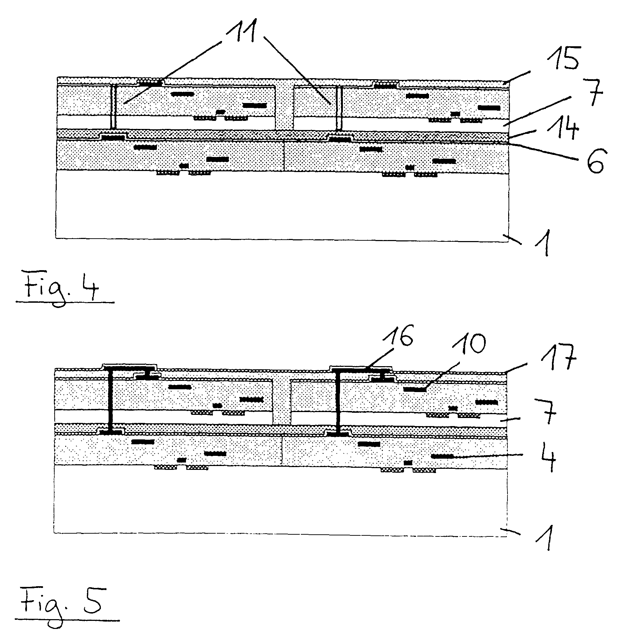

Nun wird das zweite Bauelementesubstrat 7 mit dem Handlingsubstrat 13 in einzelne Chips zerteilt. Dies kann dabei mit einem Ätzprozeß, durch Sägen oder mit einem Laser erfolgen. Daraufhin werden die gekennzeichneten, intakten Chips auf das, mit einer Haftschicht 14 versehene, erste Bauelementesubstrat 1 justiert nebeneinander aufgebracht. Die Haftschicht 14 mit einer Dicke von typischerweise 1 - 2 µm kann dabei eine Planarisierung der Oberfläche bewirken. Anschließend werden die Handlingsubstrate 13 z.B. durch Abätzen oder Abschleifen entfernt und die freiliegende Haftschicht 12 typischerweise mit einem Sauerstoffplasma oder einem Lösungsmittel ganzflächig entfernt. Nach dem Aufkleben der Chips weist die Oberfläche des ersten Substrates nun Gräben zwischen den einzelnen Chips auf, die ein sehr niedriges Aspektverhältnis besitzen. Durch einen Planarisierungsschritt, in dem die Schicht 15 abgeschieden wird, werden diese Gräben nun aufgefüllt und eine ebene Oberfläche erzeugt. Das erste Bauelementesubstrat 1 mit den beiden Bauelementeebenen läßt sich nun wie ein übliches Siliziumsubstrat mit Standard - Technologiegeräten weiterverarbeiten (Fig. 4).

Danach wird schließlich die vertikale Verbindung 16 zwischen einer Metallisierungsebene 10 der oberen Bauelementeebene (Substrat 7) und einer Metallisierungsebene 4 der unteren Bauelementeebene (Substrat 1) hergestellt. Dazu werden mit einem Photolithographieschritt ein Kontaktloch zu einer Metallisierungsebene 10 der oberen Bauelementeebene und die vorbereiteten Vialöcher 11 bis zu einer Metallisierungsebene 4 der unteren Bauelementeebene geöffnet und durch Metallabscheidung und Strukturierung eine elektrische Verbindung realisiert. Schließlich wird auf die Oberfläche noch eine Passivierungsschicht 17 abgeschieden (Fig. 5).

Die elektrische Kontaktierung kann selbstverständlich auch auf andere Weise realisiert werden, so z.B. bereits beim Aufbringen der Chips auf das untere Substrat mittels vorbereiteter Vorder- und Rückseitenkontakte (vgl. Beschreibungseinleitung: Y. Hayashi et al.).

## Patentansprüche

1. Verfahren zur Herstellung einer dreidimensionalen integrierten Schaltung mit folgenden Verfahrensschritten:
- Bereitstellen eines ersten Substrates (1), das auf einer ersten Seite eine oder mehrere fertigprozessierte Bauelementeebenen (3) enthält, die nebeneinander eine Vielzahl von unabhängigen Bauelementen oder Schaltkreisen aufweisen, wobei Bauelemente oder Schaltkreise mehrerer Bauelementeebenen Bauelementstapel bilden;
- Bereitstellen eines zweiten Substrates (7), das auf einer zweiten Seite eine oder mehrere fertigprozessierte Bauelementeebenen (9) enthält, die nebeneinander eine Vielzahl von unabhängigen Bauelementen oder Schaltkreisen aufweisen, wobei Bauelemente oder Schaltkreise mehrerer Bauelementeebenen Bauelementstapel bilden, und die Bauelemente, Bauelementstapel oder Schaltkreise zur Unterscheidung funktionsfähiger von nicht funktionsfähigen Bauelementen, Bauelementstapeln oder Schaltkreisen auf ihre Funktionsfähigkeit geprüft sind;
- Verbinden des zweiten Substrates (7) mit einem Hilfssubstrat (13) auf der zweiten Seite;
- Dünnen oder Entfernen des zweiten Substrates (7) auf der Seite, die der zweiten Seite gegenüberliegt;
- Zerteilen des Hilfssubstrates (13) mit den verbundenen Bauelementeebenen zu einzelnen Chips, die jeweils funktionsfähige oder nicht funktionsfähige Bauelemente, Bauelementstapel oder Schaltkreise enthalten;
- Justiertes Aufbringen von den Chips, die funktionsfähige Bauelemente, Bauelementstapel oder Schaltkreise enthalten, nebeneinander auf das erste Substrat (1) auf der ersten Seite;
- Entfernen des Hilfssubstrates (13);
- Herstellen der elektrischen Kontakte zwischen den Bauelementen, Bauelementstapeln oder Schaltkreisen der aufgebrachten Chips und den Bauelementen, Bauelementstapeln oder Schaltkreisen des ersten Substrates, wobei dieser Verfahrensschritt bereits beim Aufbringen der Chips erfolgen kann.

2. Verfahren nach Anspruch 1,
**dadurch gekennzeichnet,**
daß das Bereitstellen des zweiten Substrates folgende Verfahrensschritte umfaßt:
- Bereitstellen eines zweiten Substrates (7), das auf einer zweiten Seite eine oder mehrere fertigprozessierte Bauelementeebenen (9) enthält, die nebeneinander eine Vielzahl von unabhängigen Bauelementen oder Schaltkreisen aufweisen, wobei Bauelemente oder Schaltkreise mehrerer Bauelementeebenen Bauelementstapel bilden, und
- Funktionstest der einzelnen Bauelemente, Bauelementstapel oder Schaltkreise des zweiten Substrates zur Unterscheidung funktionsfähiger von nicht funktionsfähigen Bauelementen, Bauelementstapeln oder Schaltkreisen.

3. Verfahren nach Anspruch 1 oder 2,
**dadurch gekennzeichnet,**
daß zum Aufbau einer dreidimensionalen integrierten Schaltung mit mehr als zwei Bauelementeebenen das Verfahren mehrmals nacheinander durchgeführt wird, wobei als erstes Substrat bei jeder wiederholten Durchführung des Verfahrens das bearbeitete erste Substrat des jeweils vorangehenden Verfahrens verwendet wird.

4. Verfahren nach einem der Ansprüche 1 bis 3,
**dadurch gekennzeichnet,**
daß erstes und zweites Substrat jeweils genau eine Bauelementeebene enthalten.

5. Verfahren nach einem der Ansprüche 1 bis 4,
**dadurch gekennzeichnet,**
daß das Hilfssubstrat (13) über eine Haftschicht (12) mit dem zweiten Substrat (7) verbunden wird.

6. Verfahren nach einem der Ansprüche 1 bis 5,
**dadurch gekennzeichnet,**
daß die Chips mittels einer Haftschicht (14) auf die erste Seite des ersten Substrates (1) aufgebracht werden.

7. Verfahren nach Anspruch 5 oder 6,
**dadurch gekennzeichnet,**
daß eine Haftschicht mit passivierenden Eigenschaften verwendet wird.

8. Verfahren nach einem der Ansprüche 5 bis 7,
**dadurch gekennzeichnet,**
daß eine Haftschicht verwendet wird, die eine Planarisierung der Oberfläche bewirkt.

9. Verfahren nach einem der Ansprüche 1 bis 8,
**dadurch gekennzeichnet,**
daß Gräben, die nach dem justierten Aufbringen der einzelnen Chips zwischen diesen entstehen, planarisiert werden.

10. Verfahren nach einem der Ansprüche 1 bis 9,
**dadurch gekennzeichnet,**
daß das Herstellen der elektrischen Kontakte zwischen den Bauelementen, Bauelementstapeln oder Schaltkreisen der aufgebrachten Chips und den Bauelementen, Bauelementstapeln oder Schaltkreisen des ersten Substrates über Kontakt- und/oder Vialöcher (11) erfolgt.

11. Verfahren nach einem der Ansprüche 1 bis 10,
**dadurch gekennzeichnet,**
daß das Dünnen des zweiten Substrates (7) mittels Ätzen und/oder Schleifen erfolgt.

12. Verfahren nach einem der Ansprüche 1 bis 11,
**dadurch gekennzeichnet,**
daß ein SOI-Substrat als zweites Substrat (7) verwendet wird.

## Claims

1. Method of manufacturing a three-dimensional
integrated circuit having the following method steps:
- providing a first substrate (1) which contains on a first side one or more ready-processed component levels (3), which have beside one another a large number of independent components or circuits, components or circuits of a plurality of component levels forming component stacks;
- providing a second substrate (7) which contains on a second side one or more ready-processed component levels (9) which have beside one another a large number of independent components or circuits, components or circuits of a plurality of component levels forming component stacks, and the components, component stacks or circuits being tested for their ability to function in order to distinguish functioning from non-functioning components, component stacks or circuits;
- connecting the second substrate (7) to an auxiliary substrate (13) on the second side;
- thinning or removing the second substrate (7) on the side facing the second side;
- dividing the auxiliary substrate (13) with the connected component levels into individual chips which respectively contain functioning or nor-functioning components, component stacks or circuits;
- justified application of the chips which contain functioning components, component stacks or circuits, beside one another to the first substrate (1) on the first side;
- removing the auxiliary substrate (13);
- producing the electrical contacts between the components, component stacks or circuits of the applied chips and the components, component stacks or circuits of the first substrate, it being possible for this method step to take place already during the application of the chips.

2. Method according to claim 1,
**characterised in that**
the provision of the second substrate comprises the following method steps:
- providing a second substrate (7) which contains on a second side one or more ready-processed component levels (9), which have beside one another a large number of independent components or circuits, components or circuits of a plurality of component levels forming component stacks, and
- function test of the individual components, component stacks or circuits of the second substrate to distinguish functioning from non-functioning components, component stacks or circuits.

3. Method according to claim 1 or 2,
**characterised in that**
in order to construct a three-dimensional integrated circuit having more than two component levels, the method is carried out several times in succession, the processed first substrate of the respectively preceding process being used as the first substrate each time the process is repeated.

4. Method according to one of claims 1 to 3,
**characterised in that**
the first and second substrates respectively contain exactly one component level.

5. Method according to one of claims 1 to 4,
**characterised in that**
the auxiliary substrate (13) is connected to the second substrate (7) via an adhesive layer (12).

6. Method according to one of claims 1 to 5,
**characterised in that**
the chips are applied by means of an adhesive layer (14) to the first side of the first substrate (1).

7. Method according to claim 5 or 6,
**characterised in that**
an adhesive layer with passivating properties is used.

8. Method according to one of claims 5 to 7,
**characterised in that**
an adhesive layer is used which causes planarisation of the surface.

9. Method according to one of claims 1 to 8,
**characterised in that**
the trenches which occur between the individual chips after the justified application of same, are planarised.

10. Method according to one of claims 1 to 9,
**characterised in that**
the electrical contacts between the components, component stacks or circuits of the applied chips and the components, component stacks or circuits of the first substrate are produced through contact holes and/or via-holes (11).

11. Method according to one of claims 1 to 10,
**characterised in that**
the second substrate (7) is thinned by means of etching and/or polishing.

12. Method according to one of claims 1 to 11,
**characterised in that**
an SOI substrate is used as the second substrate (7).

## Revendications

1. Procédé de fabrication d'un circuit intégré tridimensionnel comprenant les étapes suivantes :
- on réalise un premier substrat (1) qui possède sur une première face, un ou plusieurs plans à composants (3) dont le traitement est terminé, et qui ont une juxtaposition d'un grand nombre de composants ou de circuits indépendants, les composants ou circuits formant des piles de composants à plusieurs plans,
- on réalise un second substrat (7) qui présente sur sa seconde face, un ou plusieurs plans à composants (9), dont la fabrication est terminée, et qui ont en juxtaposition un grand nombre de composants ou de circuits indépendants, les composants ou circuits formant des piles de composants à plusieurs plans et les composants ou piles de composants ou circuits étant vérifiés pour distinguer les composants, piles de composants ou circuits aptes à fonctionner de ceux qui ne fonctionnent pas,
- on relie le second substrat (7) avec un substrat auxiliaire (13) sur la seconde face,
- on amincit ou on enlève le second substrat (7) de la face en regard de la seconde face,
- on divise le substrat auxiliaire (13) avec les plans de composants reliés pour former les puces séparées qui contiennent chaque fois des composants, piles de composants ou circuits aptes à fonctionner ou ne fonctionnant pas,
- on applique de manière ajustée des puces, contenant des composants, des piles de composants ou des circuits aptes à fonctionner, en les juxtaposant sur la première face du premier substrat (1),
- on élimine le substrat auxiliaire (13),
- on réalise les contacts électriques entre les composants, piles de composants et circuits des puces rapportées, et les composants, piles de composants ou circuits du premier substrat, cette étape du procédé pouvant s'effectuer dès la mise en place des puces.

2. Procédé selon la revendication 1,
caractérisé en ce que
la réalisation du second substrat comprend les étapes suivantes :
- on réalise un second substrat (7) comportant sur une seconde face un ou plusieurs plans de composants (9) dont la fabrication est terminée, ces plans ayant en juxtaposition un grand nombre de composants ou de circuits indépendants, les composants ou circuits formant des piles de composants à plusieurs plans de composants, et
- on contrôle le fonctionnement des différents composants, piles de composants ou circuits du second substrat pour distinguer les composants, piles de composants et circuits aptes à fonctionner de ceux qui ne fonctionnent pas.

3. Procédé selon la revendication 1 ou 2,
caractérisé en ce que
pour construire un circuit intégré tridimensionnel avec plus de deux plans de composants, on exécute plusieurs fois successivement le procédé, le premier substrat utilisé à chaque répétition du procédé étant le premier substrat résultant du procédé précédent.

4. Procédé selon l'une quelconque des revendications 1 à 3,
caractérisé en ce que
le premier et le second substrat contiennent chaque fois exactement un plan de composants.

5. Procédé selon l'une quelconque des revendications 1 à 4,
caractérisé en ce que
le substrat auxiliaire (13) est relié au second substrat (7) par une couche adhésive (12).

6. Procédé selon l'une quelconque des revendications 1 à 5,
caractérisé en ce que
les puces sont installées sur la première face du premier substrat (1) par l'intermédiaire d'une couche adhésive (14).

7. Procédé selon la revendication 5 ou 6,
caractérisé en ce qu'
on utilise une couche adhésive avec des propriétés de passivation.

8. Procédé selon l'une quelconque des revendications 5 à 7,
caractérisé en ce qu'
on utilise une couche adhésive qui aplanit la surface supérieure.

9. Procédé selon l'une quelconque des revendications 1 à 8,
caractérisé en ce qu'
on aplanit les sillons formés entre les différentes puces appliquées de manière ajustée.

10. Procédé selon l'une quelconque des revendications 1 à 9,
caractérisé en ce qu'
on réalise les contacts électriques entre les composants, piles de composants ou circuits des puces rapportées et les composants, piles de composants ou circuits du premier substrat par des trous de contact et/ou de liaison (11).

11. Procédé selon l'une quelconque des revendications 1 à 10,
caractérisé en ce qu'
on amincit le second substrat (7) par attaque chimique et/ou meulage.

12. Procédé selon l'une quelconque des revendications 1 à 11,
caractérisé en ce que
comme second substrat (7) on utilise un substrat SOI.
